# EUROPEAN PATENT SPECIFICATION

(11) **EP 1 805 804 B1**
(45) Date of publication and mention of the grant of the patent: **24.03.2010**
(21) Application number: 05796064.3
(22) Date of filing: 06.09.2005
(51) Int. Cl.: H01L 31/18, H01L 31/0264, H01L 31/0272

(54) **FORMATION OF SOLAR CELLS ON FOIL SUBSTRATES**
BILDUNG VON SOLARZELLEN AUF FOLIENSUBSTRATEN
FORMATIONS DE PILES SOLAIRES SUR DES SUBSTRATS EN FORME DE FEUILLE

(30) Priority: 18.09.2004 US 943685; 18.09.2004 US 943658
(43) Date of publication of application: 11.07.2007
(73) Proprietor: Nanosolar, Inc., Palo Alto, CA 94303 (US)
(72) Inventor: LEIDHOLM, Craig, Sunnyvale, CA 94086 (US); BOLLMAN, Brent, Belmont, CA 94002 (US)
(74) Representative: Boyce, Conor
(86) International application number: PCT/US2005/032151
(87) International publication number: WO 2006/033858

(56) References cited:
- EP-A- 1 665 390
- EP-A- 1 747 590
- WO-A1-03/007386
- US-A- 5 419 781
- US-A- 5 578 503
- US-B2- 6 518 086
- HARTMANN ET AL: 'Flexible and Light Weight Substrates for Cu(In,Ga)Se2 Solar Cells and Modules.' CONFERENCE RECORD OF THE 28TH IEEE PHOTOVOLTAIC SPECIALIST CONFERENCE. 15 September 1920 - 22 September 2000, pages 638 - 641, XP008058341

## Description

### FIELD OF THE INVENTION

The present invention relates to fabrication of photovoltaic devices and more specifically to processing and annealing of absorber layers for photovoltaic devices.

### BACKGROUND OF THE INVENTION

Efficient photovoltaic devices, such as solar cells, have been fabricated using absorber layers made with alloys containing elements of group IB, IIIA and VIA, e.g., alloys of copper with indium and/or gallium or aluminum and selenium and/or sulfur. Such absorber layers are often referred to as CIGS layers and the resulting devices are often referred to as CIGS solar cells. The CIGS absorber layer may be deposited on a substrate. It would be desirable to fabricate such an absorber layer on an aluminum foil substrate because Aluminum foil is relatively inexpensive, lightweight, and flexible. Unfortunately, current techniques for depositing CIGS absorber layers are incompatible with the use of aluminum foil as a substrate.

Typical deposition techniques include evaporation, sputtering, chemical vapor deposition, and the like. These deposition processes are typically carried out at high temperatures and for extended times. Both factors can result in damage to the substrate upon which deposition is occurring. Such damage can arise directly from changes in the substrate material upon exposure to heat, and/or from undesirable chemical reactions driven by the heat of the deposition process. Thus very robust substrate materials are typically required for fabrication of CIGS solar cells. These limitations have excluded the use of aluminum and aluminum-foil based foils.

An alternative deposition approach is the solution-based printing of the CIGS precursor materials onto a substrate. Examples of solution-based printing techniques are described, e.g., in Published PCT Application WO 2002/084708 and commonly-assigned U.S. 2005-0183767. Advantages to this deposition approach include both the relatively lower deposition temperature and the rapidity of the deposition process. Both advantages serve to minimize the potential for heat- induced damage of the substrate on which the deposit is being formed.

Although solution deposition is a relatively low temperature step in fabrication of CIGS solar cells, it is not the only step. In addition to the deposition, a key step in the fabrication of CIGS solar cells is the selenization and annealing of the CIGS absorber layer. Selenization introduces selenium into the bulk CIG or CI absorber layer, where the element incorporates into the firm, while the annealing provides the absorber layer with the proper crystalline structure. In the prior art, selenization and annealing has been performed by heating the substrate in the presence of H₂Se or Se vapor and keeping this nascent absorber layer at high temperatures for long periods of time.

While use of A1 as a substrate for solar cell devices would be desirable due to both the low cost and lightweight nature of such a substrate, conventional techniques that effectively anneal the CIGS absorber layer also heat the substrate to high temperatures, resulting in damage to A1 substrates. There are several factors that result in A1 substrate degradation upon extended exposure to heat and/or selenium-containing compounds for extended times. First, upon extended heating, the discrete layers within a Mo-coated A1 substrate can fuse and form an intermetallic back contact for the device, which decreases the intended electronic functionality of the Mo-layer. Second, the interfacial morphology of the Mo layer is altered during heating, which can negatively affect subsequent CIGS grain growth through changes in the nucleation patterns that arise on the Mo layer surface. Third, upon extended heating, A1 can migrate into the CIGS absorber layer, disrupting the function of the semiconductor. Fourth, the impurities that are typically present in the A1 foil (e.g. Si, Fe, Mn, Ti, Zn, and V) can travel along with mobile A1 that diffuses into the solar cell upon extended heating, which can disrupt both the electronic and optoelectronic function of the cell. Fifth, when Se is exposed to A1 for relatively long times and at relatively high temperatures, aluminum selenide can form, which is unstable. In moist air the aluminum selenide can react with water vapor to form aluminum oxide and hydrogen selenide. Hydrogen selenide is a highly toxic gas, whose free formation can pose a safety hazard. For all these reasons, high-temperature deposition, annealing, and selenization are therefore impractical for substrates made of aluminum or aluminum alloys.

Because of the high-temperature, long-duration deposition and annealing steps, CIGS solar cells cannot be effectively fabricated on aluminum substrates (e.g. flexible foils comprised of A1 and/or Al-based alloys) and instead must be fabricated on heavier substrates made of more robust (and more expensive) materials, such as stainless steel, titanium, or molybdenum foils, glass substrates, or metal- or metal-oxide coated glass. Thus, even though CIGS solar cells based on aluminum foils would be more lightweight, flexible, and inexpensive than stainless steel, titanium, or molybdenum foils, glass substrates, or metal- or metal-oxide coated glass substrates, current practice does not permit aluminum foil to be used as a substrate.

WO03/007386 discloses a photovoltaic device, comprising: an electrically conductive aluminum foil substrate; at least one electrically conductive base electrode layer comprising a layer of molybdenum; an adhesion layer positioned between the aluminum foil substrate and the electrode layer, said adhesion layer comprising chromium; and an absorber layer containing one or more elements of group IB, IIIA and VIA disposed on the aluminum foil substrate.

### SUMMARY

It is an object of the present invention to provide an improved fabrication process to protect the aluminum substrate during fabrication,

The present invention provides an improved method of forming an absorber layer of a photovoltaic device according to claim 1. Further advantageous embodiments are recited in the dependent claims.

### BRIEF DESCRIPTION OF THE DRAWINGS

The teachings of the present invention can be readily understood by considering the following detailed description in conjunction with the accompanying drawings, in which:

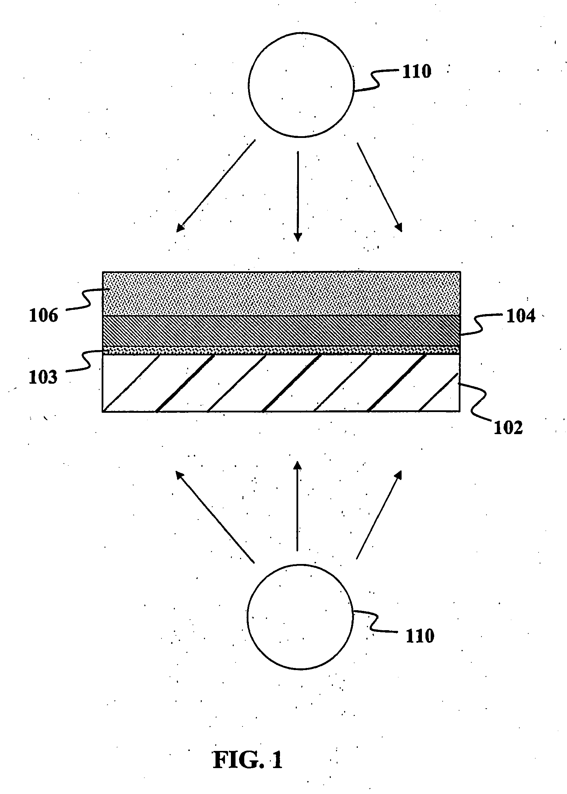

FIG. 1 is a cross-sectional schematic diagram illustrating fabrication of an absorber layer according to an embodiment of the present invention.

### DESCRIPTION OF THE SPECIFIC EMBODIMENTS

Although the following detailed description contains many specific details for the purposes of illustration, anyone of ordinary skill in the art will appreciate that many variations and alterations to the following details are within the scope of the invention. Accordingly, the exemplary embodiments of the invention described below are set forth without any loss of generality to, and without imposing limitations upon, the claimed invention.

Embodiments of the present invention allow fabrication of CIGS absorber layers on aluminum foil substrates. According to embodiments of the present invention, a nascent absorber layer containing elements of group IB and IIIA formed on an aluminum substrate by solution deposition may be annealed by rapid heating from an ambient temperature to a plateau temperature range of between about 200°C and about 600°C. The temperature is maintained in the plateau range for between about 2 minutes and about 30 minutes, and subsequently reduced. Alternatively, in an example not part of the invention, the annealing temperature could be modulated to oscillate within a temperature range without being maintained at a particular plateau temperature.

FIG. 1 depicts a partially fabricated photovoltaic device 100, and a rapid heating unit 110 the device generally includes an aluminum foil substrate 102, an optional base electrode 104, and a nascent absorber layer 106. The aluminum foil substrate 102 may be approximately 5 microns to one hundred or more microns thick and of any suitable width and length. The aluminum foil substrate 102 may be made of aluminum or an aluminum-based alloy. Alternatively, the aluminum foil substrate 102 may be made by metallizing a polymer foil substrate, where the polymer is selected from the group of polyesters, polyethylene naphtalates, polyetherimides, polyethersulfones, polyetheretherketones, polyimides, and/or combinations of the above. By way of example, the substrate 102 may be in the form of a long sheet of aluminum foil suitable for processing in a roll-to-roll system. The base electrode 104 is made of an electrically conducive material compatible with processing of the nascent absorber layer 106. By way of example, the base electrode 104 may be a layer of molybdenum, e.g., about 0.1 to 25 microns thick, and more preferably from about 0.1 to 5 microns thick. The base electrode layer may be deposited by sputtering or evaporation or, alternatively, by chemical vapor deposition (CVD), atomic layer deposition (ALD), sol-gel coating, electroplating and the like.

Aluminum and molybdenum can and often do inter-diffuse into one another, with deleterious electronic and/or optoelectronic effects on the device 100. To inhibit such inter-diffusion, an intermediate, interfacial layer 103 may be incorporated between the aluminum foil substrate 102 and molybdenum base electrode 104. The interfacial layer may be composed of compounds such as nitrides (including tantalum nitride, tungsten nitride, and silicon nitride) oxides and/or carbides. The thickness of this layer can range from 10 nm to 50 nm, and more preferably from 10 nm to 30 nm.

The nascent absorber layer 106 includes material containing elements of groups 1B, IIIA, and (optionally) VIA. Preferably, the absorber layer copper (Cu) is the group IB element, Gallium (Ga) and/or Indium (In) and/or Aluminum may be the group IIIA elements and Selenium (Se) and/or Sulfur (S) as group VIA elements, The group VIA element may be incorporated into the nascent absorber layer 106 when it is initially solution deposited or during subsequent processing to form a final absorber layer from the nascent absorber layer 106. The nascent absorber layer 106 may be about 1000 nm thick when deposited. Subsequent rapid thermal processing and incorporation of group VIA elements may change the morphology of the resulting absorber layer such that it increases in thickness (e.g., to about twice as much as the nascent layer thickness under some circumstances).

Fabrication of the absorber layer on the aluminum foil substrate 102 is relatively straightforward. First, the nascent absorber layer is deposited on the substrate 102 either directly on the aluminum or on an uppermost layer such as the electrode 104. By way of example, and without loss of generality, the nascent absorber layer is deposited in the form of a film of a solution-based precursor material containing nanoparticles that include one or more elements of groups IB, IIIA and (optionally) VIA. Examples of such films of such solution-based printing techniques are described e.g., in commonly-assigned U.S. 2005-0183767, entitled "SOLUTION-BASED FABRICATION OF PHOTOVOLTAIC CELL" and also in PCT Publication WO 02/084708, entitled "METHOD

OF FORMING SEMICONDUCTOR COMPOUND FILM FOR FABRICATION OF ELECTRONIC DEVICE AND FILM PRODUCED BY SAME".

Alternatively but not included in the invention, the nascent absorber layer 106 may be formed by a sequence of atomic layer deposition reactions or any other conventional process normally used for forming such layers. Atomic layer deposition of IB-IIIA-VIA absorber layers is described, e.g., in commonly-assigned, US 2005-0186342, entitled "FORMATION OF CIGS ABSORBER LAYER MATERIALS USING ATOMIC LAYER DEPOSITION AND HIGH THROUGHPUT SURFACE TREATMENT ON COILED FLEXIBLE SUBSTRATES".

The nascent absorber layer 106 is then annealed by flash heating it and/or the substrate 102 from an ambient temperature to an average plateau temperature range of between about 200°C and about 600°C with the heating unit 110. The heating unit 110 preferably provides sufficient heat to rapidly raise the temperature of the nascent absorber layer 106 and/or substrate 102 (or a significant portion thereof) e.g., at between about 5 C°/sec and about 150 C°/sec. By way of example, the heating unit 110 may include one or more infrared (IR) lamps that provide sufficient radiant heat. By way of example, 8 IR lamps rated at about 500 watts each situated about 1/8" (3.1750mum) to about 1 " (25.4mm) from the surface of the substrate 102 (4 above and 4 below the substrate, all aimed towards the substrate) can provide sufficient radiant heat to process a substrate area of about 25 cm² per hour in a 4" (101.6000mm) tube furnace. The lamps may be ramped up in a controlled fashion, e.g., at an average ramp rate of about 10 C°/sec. Those of skill in the art will be able to devise other types and configurations of heat sources that may be used as the heating unit 110. For example, in a roll-to-roll manufacturing line, heating and other processing can be carried out by use of IR lamps spaced 1" (25.4mm) apart along the length of the processing region, with IR lamps equally positioned both above and below the substrate, and where both the IR lamps above and below the substrate are aimed towards the substrate. Alternatively, IR lamps could be placed either only above or only below the substrate 102, and/or in configurations that augment lateral heating from the side of the chamber to the side of the substrate 102.

The absorber layer 106 and/or substrate 102 are maintained in the average plateau temperature range for between about 2 minutes and about 30 minutes. For example, the temperature may be maintained in the desired range by reducing the amount of heat from the heating unit 110 to a suitable level. In the example of IR lamps, the heat may be reduced by simply turning off the lamps. Alternatively, the lamps may be actively cooled. The temperature of the absorber layer 106 and/or substrate 102 is subsequently reduced to a suitable level, e.g., by further reducing or shutting off the supply of heat from the heating unit 110.

In embodiments of the invention, two or more discrete or continuous annealing stages are sequentially carried out, in which group VIA elements such as selenium or sulfur are incorporated in a second or latter stage. For example, the nascent absorber layer 106 may be exposed to H₂Se gas, H₂S gas or Se vapor before or during flash heating or rapid thermal processing (RTP). In this embodiment, the relative brevity of exposure allows the aluminum substrate to better withstand the presence of these gases and vapors, especially at high heat levels.

Once the nascent absorber layer 106 has been annealed additional layers may be formed to complete the device 100. For example a window layer is typically used as a junction partner for the absorber layer. By way of example, the junction partner layer may include cadmium sulfide (CdS), zinc sulfide (ZnS), or zinc selenide (ZnSe) or some combination of two or more of these. Layers of these materials may be deposited, e.g., by chemical bath deposition, chemical surface deposition, or spray pyrolysis, to a thickness of about 50 nm to about 100 nm. In addition, a transparent electrode, e.g., a conductive oxide layer, may be formed on the window layer by sputtering, vapor deposition, CVD, ALD, electrochemical atomic layer epitaxy and the like.

Embodiments of the present invention overcome the disadvantages associated with the prior art by rapid thermal processing of nascent CIGS absorber layers deposited or otherwise formed on aluminum substrates. Aluminum substrates are much cheaper and more lightweight than conventional substrates. Thus, solar cells based on aluminum substrates can have a lower cost per watt for electricity generated and a far shorter energy payback period when compared to conventional silicon-based solar cells. Furthermore aluminum substrates allow for a flexible form factor that permits both high-throughput roll-to-roll printing during solar cell fabrication and faster and easier installation processes during solar module and system installation.

Embodiments of the present invention allow the fabrication of lightweight and inexpensive photovoltaic devices on aluminum substrates. Flash heating / rapid thermal processing of the nascent absorber layer 106 allows for proper annealing and incorporation of group VIA elements without damaging or destroying the aluminum foil substrate 102. The plateau temperature range is sufficiently below the melting point of aluminum (about 660°C) to avoid damaging or destroying the aluminum foil substrate. The use of aluminum foil substrates can greatly reduce the materials cost of photovoltaic devices, e.g., solar cells, made on such substrates thereby reducing the cost per watt. Economies of scale may be achieved by processing the aluminum foil substrate in a roll-to-roll fashion, with the various layers of the photovoltaic devices being built up on the substrate as it passes through a series of deposition annealing and other processing stages.

While the above is a complete description of the preferred embodiment of the present invention, it is possible to use various alternatives, modifications and equivalents. Therefore, the scope of the present invention should be determined not with reference to the above description but should, instead, be determined with reference to the appended claims, along with their full scope of equivalents.

## Claims

1. A method for forming an absorber layer of a photovoltaic device, comprising the steps of:
providing a substrate comprising at least one electrically conductive aluminum foil substrate (102), at least one interface layer (103) including at least one material selected from the group consisting of a carbide, an oxide, a nitride, tantalum nitride, tungsten nitride and silicon nitride, and at least one electrically conductive base electrode layer (104) comprising a layer of molybdenum, wherein the interface layer is positioned between the aluminum foil substrate and the base electrode layer and wherein the interface layer acts as a diffusion barrier to inhibit inter-diffusion of molybdenum in the electrode and aluminum in the substrate during heating, and,
forming a nascent absorber layer (106) containing one or more elements of group IB. IIIA and VIA on the aluminum foil substrate **characterized by**:
depositing the nascent absorber layer from a solution of nanoparticulate precursor materials;
annealing the deposited nascent absorber layer and/or substrate by:
rapidly heating the nascent absorber layer and/or substrate from an ambient temperature to a plateau temperature range of between 200°C and 600°C at a rate of between 5 C°/sec and 150 C°/sec;
maintaining the absorber layer and/or substrate in the plateau temperature range for between 2 minutes and 30 minutes; and
reducing the temperature of the absorber layer and/or substrate; and
incorporating one or more group VIA elements into the absorber layer in a second or later annealing stage.

2. The method of claim 1 wherein the one or more group VIA elements include selenium.

3. The method of claim 1 wherein the one or more group VIA elements include sulfur.

4. The method of claim 1 wherein rapidly heating the nascent absorber layer and/or substrate is performed by radiant heating of the nascent absorber layer and/or substrate.

5. The method of claim 4 wherein one or more infrared lamps apply the radiant heating.

6. The method of claim 1 wherein the steps of terming and rapidly heating the nascent absorber layer take place as the substrate passes through roll-to-roll processing.

7. The method of claim 1. wherein the aluminum foil substrate has a thickness of at least about 5 microns or more.

8. The method of claim 1 wherein said annealing stages are either discrete or continuous.

## Patentansprüche

1. Verfahren zum Bilden einer Absorberschicht einer photovoltaischen Vorrichtung, das die folgenden Schritte beinhaltet:
Bereitstellen eines Substrats, das Folgendes umfasst: wenigstens ein elektrisch leitendes Aluminiumfoliensubstrat (102), wenigstens eine Grenzflächenschicht (103) mit wenigstens einem Material, das ausgewählt ist aus der Gruppe bestehend aus einem Carbid, einem Oxid, einem Nitrid, Tantalnitrid, Wolframnitrid und Siliciumnitrid, und wenigstens eine elektrisch leitende Basiselektrodenschicht (104), die eine Schicht aus Molybdän umfasst, wobei die Grenzflächcnschicht zwischen dem Atuminiumfoliensubstrat und der Basiselektrodenschicht liegt und wobei die Grenzflächenschicht als Diffusionsbarriere dient, um eine Interdiffusion von Molybdän in der Elektrode und Aluminium in dem Substrat während des Erhitzens zu verhindern, und
Bilden einer naszierenden Absorberschicht (106), die ein oder mehrere Elemente der Gruppe IB, IIIA und VIA auf dem Aluminiumfoliensubstrat enthält, **gekennzeichnet durch**:
Auftragen der naszierenden Absorberschicht von einer Lösung aus nanopartikelförmigen Vorläufermaterialien;
Glühen der aufgetragenen naszierenden Absorberschicht und/oder des Substrats durch:
rasches Erhitzen der naszierenden Absorberschicht und/oder des Substrats von einer Umgebungstemperatur auf einen Platcautemperaturbereich zwischen 200°C und 600°C mit einer Rate zwischen 5°C/Sek. und 150°C/Sek;
Halten der Absorberschicht und/oder des Substrats im Plateautemperaturbereich für einen Zeitraum zwischen 2 Minuten und 30 Minuten; und
Senken der Temperatur der Absorberschicht und/oder des Substrats; und
Einbauen von einem oder mehreren Elementen der Gruppe VIA in die Absorberschicht in einer zweiten oder späteren Glühstufe.

2. Verfahren nach Anspruch 1, wobei das/die eine oder mehreren Elemente der Gruppe VIA Selenium enthält/enthalten.

3. Verfahren nach Anspruch 1, wobei das/die eine oder mehreren Elemente der Gruppe VIA Schwelel enthält/enthalten.

4. Verfahren nach Anspruch 1, wobei das rasche Erhitzen der naszierenden Absorberschicht und/oder des Substrats durch Strahlungserhitzung der naszierenden Absorberschicht und/oder des Substrats erfolgt.

5. Verfahren nach Anspruch 4, wobei die Strahlungserhitzung durch eine oder mehrere Infrarotlampen erfolgt.

6. Verfahren nach Anspruch 1, wobei die Schritte des Bildens und raschen Erhitzens der naszierenden Absorberschicht ausgeführt werden, während das Substrat eine Roll-to-Roll-Verarbeitung durchläuft.

7. Verfahren nach Anspruch 1, wobei das Aluminiumfoliensubstrat eine Dicke von wenigstens etwa 5 Mikron oder mehr hat.

8. Verfahren nach Anspruch 1, wobei die genannten Glühstufen entweder diskret oder kontinuierlich sind.

## Revendications

1. Un procédé de formation d'une couche absorbante d'un dispositif photovoltaïque, comprenant les opérations suivantes :
la fourniture d'un substrat comprenant au moins un substrat en feuille d'aluminium électriquement conducteur (102), au moins une couche d'interface (103) contenant au moins un matériau sélectionné dans le groupe se composant de : un carbure, un oxyde, un nitrure, nitrure de tantale, nitrure de tungstène et nitrure de silicium, et au moins une couche d'électrode de base électriquement conductrice (104) comprenant une couche de molybdène, où la couche d'interface est placée entre le substrat en feuille d'aluminium et la couche d'électrode de base et où la couche d'interface joue le rôle de barrière de diffusion de façon à inhiber l'inter-diffusion de molybdène dans l'électrode et l'aluminium du substrat au cours du chauffage, et,
la formation d'une couche absorbante fraîche (106) contenant un ou plusieurs éléments du groupe IB, IIIA et VIA sur le substrat en feuille d'aluminium, **caractérisée par** :
le dépôt de la couche absorbante fraîche à partir d'une solution de matériaux précurseurs nanoparticulaires,
la recuisson de la couche absorbante fraîche déposée et/ou du substrat par :
le chauffage rapide de la couche absorbante fraîche et/ou du substrat à partir d'une température ambiante jusqu'à une plage de températures plateau située entre 200°C et 600°C à une vitesse située entre 5°C/sec et 150°C/sec,
le maintien de la couche absorbante et/ou du substrat dans la plage de températures plateau pendant une durée de 2 minutes à 30 minutes, et
la réduction de la température de la couche absorbante et/ou du substrat, et
l'incorporation d'un ou plusieurs éléments du groupe VIA dans la couche absorbante au cours d'une deuxième opération de recuisson ou une opération de recuisson ultérieure.

2. Le procédé selon la Revendication 1 où les un ou plusieurs éléments du groupe VIA comprennent du sélénium.

3. Le procédé selon la Revendication 1 où les un ou plusieurs éléments du groupe VIA comprennent du soufre.

4. Le procédé selon la Revendication 1 où le chauffage rapide de la couche absorbante fraîche et/ou du substrat est exécuté par un chauffage rayonnant de la couche absorbante fraîche et/ou du substrat.

5. Le procédé selon la Revendication 4 où une ou plusieurs lampes à infrarouge appliquent le chauffage rayonnant.

6. Le procédé selon la Revendication 1 où les opérations de formation et de chauffage rapide de la couche absorbante fraîche se déroulent au moment où le substrat subit un traitement rouleau à rouleau.

7. Le procédé selon la Revendication 1 où le substrat en feuille d'aluminium possède une épaisseur d'au moins environ 5 microns ou plus.

8. Le procédé selon la Revendication 1 où lesdites opérations de recuisson sont soit discrètes ou continues.
